# EUROPEAN PATENT SPECIFICATION

(11) **EP 0 796 552 B1**
(45) Date of publication and mention of the grant of the patent: **12.03.2003**
(21) Application number: 95941315.4
(22) Date of filing: 11.12.1995
(51) Int. Cl.: H05K 13/02, H05K 13/04

(54) **A METHOD AND A DEVICE FOR MOVING, IN PARTICULAR REPLACING, SUBSTRATE BOARDS IN A COMPONENT MOUNTING MACHINE**
VERFAHREN UND EINRICHTUNG ZUM BEWEGEN, INSBESONDERE ZUM ERSETZEN VON SUBSTRATPLATTEN IN EINER BESTÜCKUNGSEINRICHTUNG
PROCEDE ET DISPOSITIF POUR DEPLACER ET, EN PARTICULIER, REMPLACER DES CARTES A SUBSTRATS IMPRIMES DANS UNE MACHINE DE MONTAGE DE COMPOSANTS ELECTRONIQUES

(30) Priority: 09.12.1994 SE 9404298
(43) Date of publication of application: 24.09.1997
(73) Proprietor: Mydata Automation AB, 168 66 Bromma (SE)
(72) Inventor: JACOBSSON, Nils, S-175 63 Järfälla (SE)
(74) Representative: Rosenquist, Per Olof
(86) International application number: SE9501495
(87) International publication number: WO96018286

(56) References cited:
- IBM TECHNICAL DISCLOSURE BULLETIN, Volume 27, No. 12, May 1985, UNKNOWN AUTHOR, "Adaptable Automatic Circuit Board Transportation System", pages 6876-6877.
- PATENT ABSTRACTS OF JAPAN, Vol. 13, No. 126, E-734; & JP,A,63 294 000, (SANYO ELECTRIC CO LTD), 30 November 1988.
- PATENT ABSTRACTS OF JAPAN, Vol. 13, No. 338, E-795; & JP,A,01 099 298 (SANYO ELECTRIC CO. LTD.), 18 April 1989.
- PATENT ABSTRACTS OF JAPAN, Vol. 13, No. 323, E-791; & JP,A,01 090 600, (SANYO ELECTRIC CO LTD), 7 April 1989.
- PATENT ABSTRACTS OF JAPAN, Vol. 13, No. 323, E-791; & JP,A,01 090 599 (SANYO ELECTRIC CO LTD), 7 April 1989.

## Description

### FIELD OF THE INVENTION

The present invention relates to a method and devices for handling circuit boards, in particular feeding and expelling circuit boards in mounting electronic components and similar items thereon in an automatic mounting machine or automaton.

### BACKGROUND

Higher and higher requirements are posed on the velocity in mounting electronic components. An operation that is usually time consuming is the insertion of a circuit board in a holder at the mounting machine and replacement of a circuit board by a new, non mounted board, when the mounting of components on the first board is finished. The replacement or boards is conventionally made manually or by means of conveyor belts.

### PRIOR ART

In IBM Technical Disclosure Bulletin Vol. 27, No. 12, May 1985, pp. 6876 - 6877 an adaptable circuit board transportation system is disclosed where a circuit board 14 is transported from a carriage 12 on to transfer rails in an operation station 18.

### SUMMARY

It is an object of the invention to provide a method and devices by means of which a replacement of boards can be rapidly made in a component mounting machine.

This object is achieved by the invention, the more detailed features of which appear from the appended claims.

When substrate boards, in particular circuit boards, are moved on, to or from a component mounting machine the boards are not conveyed one by one but in the shape of board trains, i.e. groups of boards placed closely at each other, where thus the inner, transverse edges of the boards are in contact with each other.

In a replacement of boards thus simultaneously a row of circuit boards or generally substrate boards for some sort of components, e.g. 3 to 5 boards, that are located at each other, is replaced. They are pushed in the shape of a train or one unit in to a suitable place in the mounting machine, e.g. on a wagon belonging thereto that is laterally movable. In the same way the same number of boards in the shape of a board train is pushed away from the mounting machine. A suitably shaped arm or other suitable means can contact the outer edge of the outermost board in such a group of circuit boards on the mounting machine that are located at each other.

In a preferred embodiment a displacement or actuating means is arranged only on a transport device that is placed at a side of the machine and that simultaneously displaces a packed group of boards in to the machine and a group of boards, the mounting of which has been finished, away from the machine. Such an actuating means can have rigidly connected arms which, when they are activated, come into contact with the outermost edge of a board in the board group comprising boards both on the transport device and on the machine.

In some cases only the new group of boards must be acted on by a displacement means, so that the new group, at the outer edge that is opposite to the edge where the displacement means operates, comes into contact with an outer edge of a board in the group of circuit boards, for which the mounting has already been finished so that the two groups move as one unit, one group in to the mounting machine and the other group away from the mounting machine.

As an actuation or displacement means preferably some conventional type of linear motor is used, such as fluid driven cylinder assembly. At the piston rod thereof then two projections or arms can be arranged for contacting two different groups or "trains" of boards, one group being located on the machine. It is also possible to use endless conveyor belts which engage with the lateral edges of the substrate boards, the lateral edges being those edges which are parallel to the transport direction.

For guiding the circuit boards parallel grooves are required for receiving the edges of the circuit boards, the width or height of the grooves being adapted to the thickness of the circuit boards, in particular so that the width is less than double the thickness of the side edges of the boards, and that the distance of the grooves from each other is adapted to the width of the circuit boards.

### BRIEF DESCRIPTION OF THE DRAWINGS

The invention will now be described by way of a non limiting exemplary embodiment with reference to the accompanying drawings in which
Fig. 1 is a perspective view of a handling device for transport of substrate boards up to and from a component mounting machine,
Fig. 2 is a side view of a component mounting machine comprising a handling device of the kind illustrated in Fig. 1,
Fig. 3 is a fragmentary view illustrating guide grooves, and
Fig. 4 is a plan view of the component mounting machine of Fig. 2.

### DETAILED DESCRIPTION

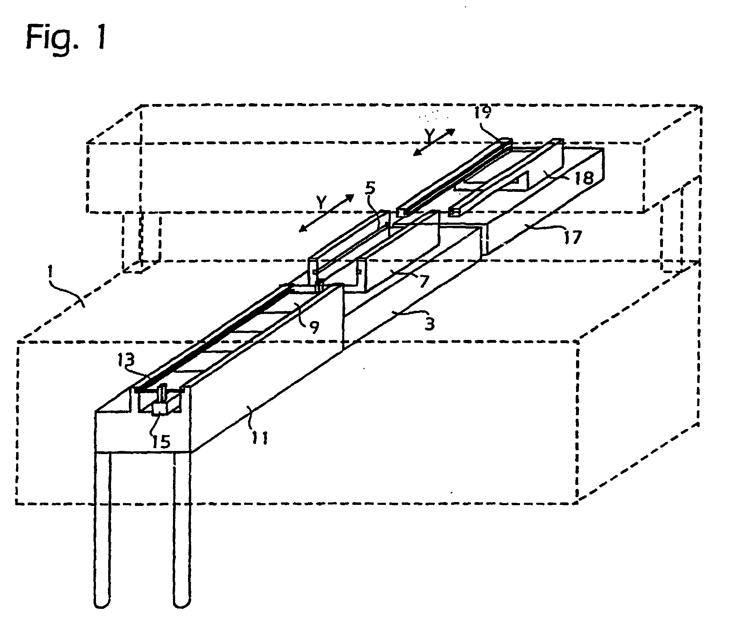

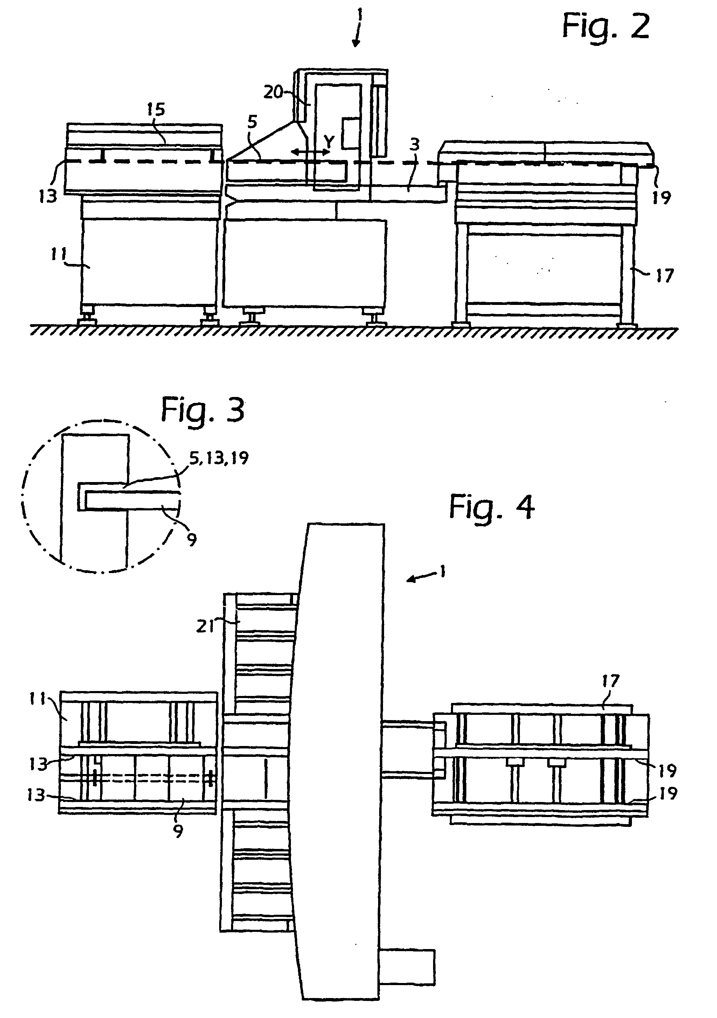

In Fig. 1 an automatic component mounting machine 1 is indicated in dotted lines, on the table of which an Y-wagon or Y-carriage 3 is mounted for a sliding movament in a transverse direction, the position of the Y-carrainge being accurately controlled by a control processor of the machine. The mount machine is also seen in Figs. 2 and 4 in an elevational view and a plan view respectively and it is preferably the type having a mount head, not shown, movable in one horizontal direction, the X-direction, perpendicular to the Y-direction and in a vertical direction, the Z-direction. On the top side of the wagon 3 grooves 5 are arranged in those side surfaces, that are directed inwards, of upstanding side parts 7. The length of the grooves 5 is sufficient for inserting several circuit boards 9 therein, these boards being, as is conventional, assumed to have a basically rectangular shape having two large surfaces and two transverse edges or sides parallel to each other and two lateral edges or sides also parallel to each other. The distance of the grooves 5 from each other and in particular of their inner, bottom surfaces is adapted to the width of the circuit boards 9. Further the height or the width of the grooves 9 is sufficient for receiving a lateral edge of the substrate boards 9 but insufficient for the case that several circuit boards will be arranged simultaneously in the grooves on top of each other, i.e. the width of the grooves is less than double the thickness of the lateral edges of the boards, see also the fragmentary view of Fig. 3. In order to improve the sliding movement of the boards 9 in the grooves 5 small rollers, not shown, can be arranged in a suitable manner in the grooves.

A front transport device 11 is provided with grooves in upstanding side parts. These grooves 13 are configured in the same way as the grooves 5 of the Y-wagon for receiving simultaneously several circuit boards 9 placed closely at each other. The transport device 11 is controllably movable in different ways, in particular so that its grooves 13 can be moved into alignment with the grooves 5 of the Y-wagon 3, that is it is movable in a direction perpendicular to the Y-direction. At the transport device 11 some sort of displacement means is provided for displacing the at least two circuit boards 9 located in the grooves thereof as one unit, the inner transverse sides of the circuit boards then being in contact with each other. The transport direction of the boards is thus from the front transport device to the machine 1 and the carriage 3 and therefrom to a rear transport device indicated at 17. The displacement means can be some type of fluid driven cylinder, as is indicated at 15 having one or advantageously two suitably shaped, upstanding arms on the piston rod, such as at the ends thereof. Such an arm can then come into contact with the outer transverse edge of the rearmost one of the circuit boards 9 and push all circuit boards that are located on the transport device 11 into the grooves 5 of the Y-wagon 3. Another arm can come in contact with the rear transverse edge of the outermost, rear circuit board in the group of boards, which are already placed on the Y-wagon 3. When the cylinder device 15 is suitably activated, the boards 9 which are located in the front transport device 11 can then be pushed out in the shape of a board train or as one unit from the grooves 13 thereon and in to the grooves 5 of the Y-wagon 3. The boards which are already located in the grooves 5 of the mounting machine, are then also displaced as one board train out from the Y-wagon 3.

It is also possible to construct the actuation device 15 so that is has no arm for acting on the boards which are already located on the machine 1. In that case these circuit boards can be pushed away from their places, also as one unit or as a train of boards to the rear transport device 17, by being pushed by the front, far away board, in the group of boards which are already located on the front transport device 11.

The rear transport device 17 can be configured in the same way as the front transport device 11 but is in Fig. 1 shown as having a somewhat modified construction. The upstanding parts 18 having the guide grooves 19 for receiving the board train are here thus not rectangular but extend in the shape of arms in towards the mounting machine 3. In the inner surfaces of the upstanding side parts 18 the grooves 19 are made which are configured in the same way as the grooves 5 and 13 of the Y-wagon 3 and the front transport device 11 respectively. They can, like the grooves 13 of the front transport device 11, be moved into alignment with the grooves 5 of the Y-wagon 3. In the case where several circuit boards in some way as one unit are pushed out from the grooves 5 of the Y-wagon 3, they will then be inserted in the grooves 19 of the rear transport device 17.

The mount machine 1 as depicted in Figs. 2 and 4 comprises a horizontal bar, shown generally at 20, along which a mount head, not shown, is movable. On both sides of the Y-carriage 3 magazine sites 21 are provided, these also being movable in the Y-direction and accessible, like the boards places on the Y-carriage 3, by a pick-up device, not shown, on the mount head.

The operation of the device described above is as follows. First individual boards 9 are placed in the grooves 13 on the front transport device 11. It can be made in the conventional way such as by means of suitable conveyor belts, not shown, that are used in loading circuit boards in mounting machines for electronics. The inserted boards are packed to a board train so that they will be placed having their inner, transverse edges in contact with each other. The packing can be performed by a suitable control of the cylinder assembly 15, the rear arm of which can controllably be elevated for contacting the outermost, rear circuit board that is inserted in the grooves 13. Some suitable stop device, not shown, which can also be controlled by the control system of the machine, can then be activated for stopping the front, outermost circuit board from falling out of the grooves 13.

When the packing is finished, the grooves 13 on the front transport device 11 are aligned with the grooves 5 on the Y-wagon and the same alignment is made for the grooves 19 on the rear transport device 17. The cylinder assembly 15 together with its support arms is activated in a suitable way so that the rear arm comes into engagement with the outermost transverse edge of the rear circuit board in the grooves 13 of the transport device 11 and the front one comes into engagement with the outermost, rear transverse edge of the rear circuit board in the group of boards on the Y-wagon of the machine, which are located closely at each other. Thereby the row of boards on the front transport device is moved as one unit or as a board train over to the grooves 5 of the Y-wagon and simultaneously, by means of the same movement of the movable element, i.e. of the piston rod, the boards located on the Y-wagon are transported as one unit away from the machine and into the grooves 19 of the rear transport device 17. After that the replacement of boards is finished and the boards on the Y-wagon 5 are blocked in a suitable way in order that the machine 1 will be able to perform the intended mounting of components thereon.

## Claims

1. A method of moving, in particular replacing, substrate boards in a component mounting machine, in which components are mounted on substrate boards placed in the machine, **characterized in**
**that** several substrate boards are placed in a row adjacent each other having their opposite edges in contact with neighbouring substrate boards in the machine and that the boards are moved in the machine as one unit having the edges still in contact with each other during this movement, in particular the boards being fed to the machine and/or transported away from the machine as one unit having the edges still in contact with each other during this movement.

2. A method according to claim 1, **characterized in that** in the displacement of substrate boards, in particular in feeding and/or transporting substrate boards to or away from the machine respectively, an edge of an outer substrate board in the row is acted on in a direction towards the other substrate boards in the row.

3. A method according to one of claims 1 - 2, **characterized in that** in a replacement of a row of boards located on the machine by a row of boards located at another location on the machine or thereat a rigid actuating means is displaced, so that the surface thereon acts on an edge of an outer board in a row and another surface thereon acts on an edge of an outer board in another row.

4. A method according to one of claims 1 - 3, **characterized in that** in providing a new row of substrate boards to the machine, an outer board in this row is made to come in contact with the edge of an outer board in a row of substrate boards placed in the component mounting machine, whereby the new row of substrate boards abuts or pushes the row of boards in the machine away, when the new row is acted on for being provided to the machine.

5. A device for replacing substrate boards in a component mounting machine, in which components are mounted on substrate boards placed in the machine, **characterized by** grooves (5) arranged in the machine (1) for slidably receiving opposite, first edges of the substrate boards (9) and having such a length that several substrate boards can be placed having their first edges inserted in the grooves and in a row adjacent each other having the second opposite edges of the boards in contact with neighbouring substrate boards in the machine in those cases where a neighbouring board is located at the side of the board, and actuating means (3) for moving boards received by the grooves in the machine as one unit.

6. A device according to claim 5, **characterized in that** the actuating means are arranged to act on an edge of an outer substrate board in the row of boards received in the grooves and in a direction towards the other substrate boards in the row.

7. A device according to one of claims 5 - 6, **characterized by** a transport device having grooves arranged in the same way as in the machine and movement means in the transport device for making the grooves therein aligned with corresponding grooves in the machine.

8. A device according to claim 7, **characterized in that** the transport device also comprises actuating means for displacing boards received in the grooves in the transport device as one unit.

9. A device according to claim 8, **characterized in that** these actuating means of the transport device are arranged to act on an edge of an outer substrate board in the row of boards received in the grooves and in a direction towards the other substrate boards in the row.

10. A device according to claim 8, **characterized in that** the actuating means of the transport device are arranged to also act as actuating means for displacing a row of boards received in the grooves in the machine as one unit.

11. A device for replacing substrate boards in a component mounting machine, in which components are mounted on substrate boards (9) placed in the machine, grooves (5) are arranged in the machine (1) for slidably receiving opposite first edges of the substrate boards, with a transport device (11) having grooves (13) arranged in the same way as in the machine, and movement means in the transport device for making the grooves therein to aligne with corresponding grooves in the machine, **characterized in that** the grooves in the machine and the transport device have such a length, that several substrate boards can be placed having their first edges inserted in the grooves and in a row adjacent each other and having the second opposite edges of the boards in contact with neighbouring substrate boards in the machine, in those cases where there is a neighbouring board at this side of the board, and displacement means (15) only arranged in the transport device for displacing boards in the transport device and in the machine when making a replacement of boards.

12. A device according to claim 11, **characterized in that** the displacement means comprise actuating means for displacing boards received in the grooves in the transport device as one unit and in the machine.

13. A device according to claim 12, **characterized in that** these actuating means are arranged to act on an edge of an outer substrate board in the row of boards received in the grooves in the transport device and in a direction towards the other substrate boards in the row.

14. A device according to claim 12, **characterized in that** these actuating means are arranged to act on an edge of an outer substrate boards in the row of boards received in the grooves in the transport device and in a direction towards the other substrate boards in the row and simultaneously on an edge of an outer substrate board in the row of boards received in the grooves of the machine.

15. A device according to claim 14, **characterized in that** the actuating means comprise a rigid element comprising support arms projecting therefrom for engaging side edges of outer boards in the rows.

## Patentansprüche

1. Verfahren zum Bewegen, insbesondere Austauschen, von Trägerplatten in einer Bauteilmontagemaschine, wobei die Bauteile auf Trägerplatten montiert werden, die in der Maschine angeordnet sind, **dadurch gekennzeichnet, dass**:
mehrere Trägerplatten in einer Reihe aneinandergrenzend angeordnet sind und ihre einander gegenüberliegenden Kanten mit benachbarten Trägerplatten in der Maschine in Kontakt sind, und dass die Platten in der Maschine als eine Einheit bewegt werden, wobei die Kanten während dieser Bewegung nach wie vor miteinander in Kontakt sind, und zwar insbesondere bei den Platten, die als eine Einheit der Maschine zugeführt und/oder von der Maschine wegtransportiert werden, ihre Kanten während dieser Bewegung nach wie vor in Kontakt miteinander sind.

2. Verfahren nach Anspruch 1, **dadurch gekennzeichnet, dass** bei der Verschiebung von Trägerplatten, insbesondere beim Zuführen und/oder Transportieren von Trägerplatten zu der Maschine bzw. von ihr weg, auf eine Kante einer äußeren Trägerplatte in der Reihe in einer Richtung auf die anderen Trägerplatten in der Reihe zu eingewirkt wird.

3. Verfahren nach einem der Ansprüche 1-2, **dadurch gekennzeichnet, dass** bei einem Austausch einer Reihe von Platten, die sich auf der Maschine befindet, gegen eine Reihe von Platten, die sich an einer anderen Position auf der Maschine oder daran befinden, ein starrer Betätigungsmechanismus verschoben wird, so dass die Fläche daran auf eine Kante einer äußeren Platte in einer Reihe einwirkt, und eine andere Fläche daran auf eine Kante einer äußeren Platte in einer anderen Reihe einwirkt.

4. Verfahren nach einem der Ansprüche 1-3, **dadurch gekennzeichnet, dass** beim Zuleiten einer neuen Reihe von Trägerplatten zu der Maschine eine äußere Platte in dieser Reihe mit der Kante einer äußeren Platte in einer Reihe von Trägerplatten, die in der Bauteilmontagemaschine angeordnet sind, in Kontakt gebracht wird, so dass die neue Reihe von Trägerplatten an der Reihe von Platten in der Maschine anschlägt bzw. sie wegschiebt, wenn auf die neue Reihe eingewirkt wird, die der Maschine zugeleitet wird.

5. Vorrichtung zum Austauschen von Trägerplatten in einer Bauteilmontagemaschine, wobei die Bauteile auf Trägerplatten montiert werden, die in der Maschine angeordnet sind, **gekennzeichnet durch** Nuten (5), die in der Maschine (1) angeordnet sind, um einander gegenüberliegende erste Kanten der Trägerplatten (9) verschiebbar aufzunehmen, und die so lang sind, dass mehrere Trägerplatten so, dass ihre ersten Kanten in die Nuten eingeführt werden, und in einer Reihe aneinandergrenzend angeordnet werden können, wobei die zweiten, einander gegenüberliegenden Kanten der Platten in den Fällen mit benachbarten Trägerplatten in der Maschine in Kontakt sind, in denen eine benachbarte Platte sich an der Seite der Platte befindet, sowie **durch** eine Betätigungseinrichtung (3), die von den Nuten aufgenommene Platten in der Maschine als eine Einheit bewegt.

6. Vorrichtung nach Anspruch 5, **dadurch gekennzeichnet, dass** die Betätigungseinrichtung auf eine Kante einer äußeren Trägerplatte in der Reihe von Platten, die in den Nuten aufgenommen sind, und in einer Richtung auf die anderen Trägerplatten in der Reihe zu einwirkt.

7. Verfahren nach einem der Ansprüche 5-6, **gekennzeichnet durch** eine Transportvorrichtung mit Nuten, die auf die gleiche Weise wie in der Maschine angeordnet sind, sowie eine Bewegungseinrichtung in der Transportvorrichtung, die die Nuten darin auf entsprechende Nuten in der Maschine ausrichtet.

8. Vorrichtung nach Anspruch 7, **dadurch gekennzeichnet, dass** die Transportvorrichtung des Weiteren eine Betätigungseinrichtung umfasst, die Platten, die in den Nuten in der Transportvorrichtung aufgenommen sind, als eine Einheit verschiebt.

9. Vorrichtung nach Anspruch 8, **dadurch gekennzeichnet, dass** diese Betätigungseinrichtung der Transportvorrichtung so ausgeführt ist, dass sie auf eine Kante einer äußeren Trägerplatte in der Reihe von Platten einwirkt, die in den Nuten aufgenommen sind, und zwar in einer Richtung auf die Trägerplatten in der Reihe zu.

10. Vorrichtung nach Anspruch 8, **dadurch gekennzeichnet, dass** die Betätigungseinrichtung der Transportvorrichtung so angeordnet ist, dass sie auch als Betätigungseinrichtung wirkt, die eine Reihe von Platten, die in den Nuten in der Maschine aufgenommen sind, als eine Einheit verschiebt.

11. Vorrichtung zum Austauschen von Trägerplatten in einer Bauteilmontagemaschine, wobei die Bauteile auf Trägerplatten (9) montiert werden, die in der Maschine angeordnet sind, wobei Nuten (5) in der Maschine (1) angeordnet sind, um einander gegenüberliegende erste Kanten der Trägerplatten verschiebbar aufzunehmen, mit einer Transportvorrichtung (11), die Nuten (13) aufweist, die auf die gleiche Weise wie in der Maschine angeordnet sind, und einer Bewegungseinrichtung in der Transportvorrichtung, die die Nuten darin auf entsprechende Nuten in der Maschine ausrichtet, **gekennzeichnet dadurch, dass** die Nuten in der Maschine und der Transportvorrichtung so lang sind, dass mehrere Substrate so, dass ihre ersten Kanten in die Nuten eingeführt sind, und in einer Reihe aneinandergrenzend angeordnet werden können, wobei die zweiten, einander gegenüberliegenden Kanten der Platten in den Fällen mit benachbarten Trägerplatten in der Maschine in Kontakt sind, in denen an dieser Seite der Platte eine benachbarte Platte vorhanden ist, und eine Verschiebungseinrichtung (15), die nur in der Transportvorrichtung angeordnet ist, um Platten in der Transportvorrichtung und in der Maschine zu verschieben, wenn ein Austausch von Platten ausgeführt wird.

12. Vorrichtung nach Anspruch 11, **dadurch gekennzeichnet, dass** die Verschiebeeinrichtung eine Betätigungseinrichtung umfasst, die Platten, die in den Nuten, die in der Transportvorrichtung aufgenommen sind, in der Transportvorrichtung und in der Maschine als eine Einheit verschiebt.

13. Vorrichtung nach Anspruch 12, **dadurch gekennzeichnet, dass** diese Betätigungseinrichtung auf eine Kante einer äußeren Trägerplatte in der Reihe von Platten, die in den Nuten in der Transportvorrichtung aufgenommen sind, und in einer Richtung auf die anderen Trägerplatten in der Reihe zu einwirkt.

14. Vorrichtung nach Anspruch 12, **dadurch gekennzeichnet, dass** diese Betätigungseinrichtung auf eine Kante einer äußeren Trägerplatte in der Reihe von Platten, die in den Nuten in der Transportvorrichtung aufgenommen sind, und in einer Richtung auf die anderen Trägerplatten in der Reihe zu, und gleichzeitig auf eine Kante einer äußeren Trägerplatte in der Reihe von Platten, die in den Nuten der Maschine aufgenommen sind, einwirkt.

15. Vorrichtung nach Anspruch 14, **dadurch gekennzeichnet, dass** die Betätigungseinrichtung ein starres Element umfasst, das Trägerarme umfasst, die davon vorstehen, um mit Seitenkanten von äußeren Platten in den Reihen in Eingriff zu kommen.

## Revendications

1. Procédé qui permet de déplacer, en particulier de remplacer, des cartes de substrat dans une machine de montage de composant, dans laquelle des composants sont montés sur des cartes de substrat placées dans la machine, **caractérisé en ce que** plusieurs cartes de substrat sont placées dans une rangée adjacente ayant chacune leurs bords opposés en contact avec les cartes de substrat voisines dans la machine, et **en ce que** les cartes sont déplacées dans la machine en tant qu'une unité ayant les bords encore en contact les uns avec les autres pendant ce déplacement, en particulier les cartes étant acheminées vers la machine et / ou transportées hors de la machine en tant qu'une unité ayant les bords encore en contact les uns avec les autres pendant ce déplacement.

2. Procédé selon la revendication 1, **caractérisé en ce que** dans le déplacement des cartes de substrat, en particulier dans l'acheminement et / ou le transportant des cartes de substrat vers, ou hors de la machine, respectivement, un bord d'une carte de substrat externe dans la rangée est exécuté dans une direction vers les autres cartes de substrat de la rangée.

3. Procédé selon l'une quelconque des revendications 1 ou 2, **caractérisé en ce que** dans un remplacement d'une rangée de cartes situées sur la machine par une rangée de cartes situées à un autre endroit sur la machine ou ailleurs, des moyens d'actionnement rigides sont déplacés, de sorte que la surface agisse sur un bord d'une carte externe dans une rangée et une autre surface agisse sur un bord d'une carte externe dans une autre rangée.

4. Procédé selon l'une quelconque des revendications 1 ou 3, **caractérisé en ce qu'**en fournissant une nouvelle rangée de plaques de substrat à la machine, une carte externe située dans cette rangée est incitée à entrer en contact avec le bord d'une carte externe située dans une rangée de cartes de substrat placées dans la machine de montage de composants, grâce à quoi la nouvelle rangée de cartes de substrat vient en butée ou repousse la rangée de cartes dans la machine, quand la nouvelle rangée est actionnée pour alimenter la machine.

5. Dispositif qui permet de remplacer des cartes de substrat dans une machine de montage de composants, dans laquelle des composants sont montés sur des cartes de substrat placées dans la machine, **caractérisé par** des rainures (5) disposées dans la machine (1) afin de recevoir de manière coulissante, les premiers bords des cartes de substrat (9) et ayant une longueur telle que plusieurs cartes de substrat peuvent être placées avec leurs premiers bords insérés dans les rainures et dans une rangée adjacente l'une à l'autre ayant les seconds bords opposés des cartes en contact avec les cartes de substrat voisines dans la machine dans les cas où une carte voisine est située sur le côté de la carte, et des moyens d'actionnement (3) qui permettent de déplacer les cartes reçues par les rainures dans la machine en tant qu'une unité.

6. Dispositif selon la revendication 5, **caractérisé en ce que** les moyens d'actionnement sont disposés pour agir sur un bord d'une carte de substrat externe dans la rangée de cartes reçues dans les rainures et dans une direction vers les autres cartes de substrat de la rangée.

7. Dispositif selon l'une quelconque des revendications 5 à 6, **caractérisé par** un dispositif de transport ayant des rainures disposées de la même façon que dans la machine, et des moyens de déplacement situés dans le dispositif de transport qui permettent que les rainures situées à l'intérieur, soient alignées avec les rainures correspondantes de la machine.

8. Dispositif selon la revendication 7, **caractérisé en ce que** le dispositif de transport comprend également des moyens d'actionnement qui permettent de déplacer des cartes reçues dans les rainures du dispositif de transport en tant qu'une unité.

9. Dispositif selon la revendication 8, **caractérisé en ce que** ces moyens d'actionnement du dispositif de transport sont disposés pour agir sur un bord d'une carte de substrat externe dans la rangée de cartes reçues dans les rainures et dans une direction vers les autres cartes de substrat de la rangée.

10. Dispositif selon la revendication 8, **caractérisé en ce que** les moyens d'actionnement du dispositif de transport sont disposés pour agir également en tant que moyens d'actionnement afin de déplacer une rangée de cartes reçues dans les rainures de la machine en tant qu'une unité.

11. Dispositif qui permet de remplacer les cartes de substrat dans une machine de montage de composants, dans lequel des composants sont montés sur des cartes de substrat (9) placées dans la machine, des rainures (5) sont disposées dans la machine (1) afin de recevoir de façon coulissante des premiers bords opposés de cartes de substrat, avec un dispositif de transport (11) ayant des rainures (13) disposées de la même façon que dans la machine, et des moyens de déplacement situés dans le dispositif de transport afin de faire en sorte que les rainures situées à l'intérieur s'alignent avec les rainures correspondantes dans la machine, **caractérisé en ce que** les rainures situées dans la machine et le dispositif de transport aient une longueur telle que plusieurs cartes de substrat puissent être placées ayant leurs premiers bords insérés dans les rainures et dans une rangée adjacente l'une avec l'autre et ayant les seconds bords opposés des cartes en contact avec les cartes de substrat voisines dans la machine, dans ces cas où il y a une carte voisine située sur ce côté de la carte, et des moyens de déplacement (15) disposés seulement dans le dispositif de transport afin de déplacer des cartes dans le dispositif de transport et dans la machine au moment d'un remplacement de cartes.

12. Dispositif selon la revendication 11, **caractérisé en ce que** les moyens de transport comprennent des moyens d'actionnement qui permettent de déplacer des cartes reçues dans les rainures du dispositif de transport en tant qu'une unité et dans la machine.

13. Dispositif selon la revendication 12, **caractérisé en ce que** ces moyens d'actionnement sont disposés pour agir sur un bord d'une carte de substrat externe dans la rangée de cartes reçues dans les rainures du dispositif de transport et dans une direction vers les autres cartes de substrat de la rangée.

14. Dispositif selon la revendication 12, **caractérisé en ce que** ces moyens d'actionnement sont disposés pour agir sur un bord des cartes de substrat extérieures dans la rangée de cartes reçues dans les rainures du dispositif de transport et dans une direction vers les autres cartes de substrat dans la rangée et simultanément sur un bord d'une carte de substrat extérieure de la rangée de cartes reçues dans les rainures de la machine.

15. Dispositif selon la revendication 14, **caractérisée en ce que** les moyens d'actionnement comprennent un élément rigide qui comprend des bras de support qui en font saillie afin de mettre en prise les bords latéraux des cartes extérieures dans les rangées.
